# EUROPÄISCHE PATENTSCHRIFT

(11) **EP 3 132 322 B1**
(45) Veröffentlichungstag und Bekanntmachung des Hinweises auf die Patenterteilung: **04.07.2018**
(21) Anmeldenummer: 15720607.9
(22) Anmeldetag: 09.04.2015
(51) Int. Cl.: G05B 23/02, B60R 16/023, G01R 31/00

(54) **VERFAHREN ZUR DIAGNOSE EINES KRAFTFAHRZEUGSYSTEMS, DIAGNOSEGERÄT FÜR EIN KRAFTFAHRZEUGSYSTEM, STEUERGERÄT FÜR EIN KRAFTFAHRZEUGSYSTEM UND KRAFTFAHRZEUG**
METHOD FOR DIAGNOSING A MOTOR VEHICLE SYSTEM, DIAGNOSTIC DEVICE FOR A MOTOR VEHICLE SYSTEM, CONTROL DEVICE FOR A MOTOR VEHICLE SYSTEM, AND MOTOR VEHICLE
PROCÉDÉ DE DIAGNOSTIC D'UN SYSTÈME DE VÉHICULE AUTOMOBILE, APPAREIL DE DIAGNOSTIC D'UN SYSTÈME DE VÉHICULE AUTOMOBILE, APPAREIL DE COMMANDE D'UN SYSTÈME DE VÉHICULE AUTOMOBILE ET VÉHICULE AUTOMOBILE

(30) Priorität: 16.04.2014 DE 102014207282
(43) Veröffentlichungstag der Anmeldung: 22.02.2017
(73) Patentinhaber: Volkswagen Aktiengesellschaft, 38440 Wolfsburg (DE)
(72) Erfinder: ÜBERFELDT, Frank, 38442 Wolfsburg (DE); DORER, Frank, 38518 Gifhorn (DE); MÖLLER, Felix, 10627 Berlin (DE)
(86) Internationale Anmeldenummer: PCT/EP2015/057698
(87) Internationale Veröffentlichungsnummer: WO 2015/158594

(56) Entgegenhaltungen:
- DE-A1-102005 044 236
- DE-A1-102009 053 753
- US-A1- 2004 149 024
- US-A1- 2012 166 036
- TONGUÇ ÜNLÜYURT: "Sequential testing of complex systems: a review", DISCRETE APPLIED MATHEMATICS, Bd. 142, Nr. 1-3, 1. August 2004 (2004-08-01), Seiten 189-205, XP055199213, ISSN: 0166-218X, DOI: 10.1016/j.dam.2002.08.001
- Links: "Hand-held CANopen diagnostic tool", CAN Newsletter, 1 March 2013 (2013-03-01), pages 8-11, XP055396368, Retrieved from the Internet: URL:https://can-newsletter.org/uploads/med ia/raw/83913606b3f786449cf0a816e2d51951.pd f [retrieved on 2017-08-04]

## Beschreibung

Die Erfindung betrifft ein Verfahren zur Diagnose eines Kraftfahrzeugsystems sowie eine Kombination eines Diagnosegeräts und eines Kraftfahrzeugsystems mit einem Steuergerät. Insbesondere betrifft die Erfindung ein Verfahren, Diagnosegerät und Steuergerät, bei denen zur Diagnose des Kraftfahrzeugsystems flexibel wenigstens ein Betriebszustand des Kraftfahrzeugsystems eingestellt wird; bei dem Kraftfahrzeugsystem kann es sich insbesondere um ein Antriebssystem eines Kraftfahrzeugs handeln.

Zur Steuerung von Kraftfahrzeugsystemen sind zunehmend elektronische Steuergeräte in Gebrauch, welche das Kraftfahrzeugsystem gemäß einer in einem Speicher des Steuergeräts bereitgestellten und durch eine Recheneinheit des Steuergeräts ausgeführten Software steuern. Dieser Entwicklung entsprechend wird zur Überwachung eines solchen Kraftfahrzeugsystems ebenfalls Software eingesetzt. Diese kann beispielsweise im Speicher eines Steuergeräts abgespeichert sein und das Kraftfahrzeugsystem im regulären Betrieb überwachen (On-Board-Diagnose). Insbesondere zur Fehleranalyse werden auch externe Diagnosegeräte eingesetzt, die nur zum Zwecke der Fehleranalyse oder Überprüfung des Kraftfahrzeugsystems mit dieser verbunden werden (Off-Board-Diagnose).

Die deutsche Offenlegungsschrift DE 10 2006 045 151 A1 offenbart ein Verfahren zur Diagnose eines Kraftfahrzeugs, ein zugehöriges Steuergerät eines Kraftfahrzeugs sowie einen entsprechenden Werkstatttester. Im Steuergerät ist eine Vielzahl von Diagnosemodulen gespeichert, welche bei Ausführung durch das Steuergerät definierte Diagnoseschritte durchführen. Von dem Werkstatttester wird eine Diagnoseliste übertragen, die eine Abfolge der Ausführung von einzelnen Diagnosemodulen festlegt. Zusätzlich kann direkt vom Steuergerät ausführbarer Programmcode vom Werkstatttester an das Steuergerät übertragen werden. Die Beurteilung der Funktionstauglichkeit des Kraftfahrzeugs erfolgt dabei innerhalb des Steuergeräts.

Die deutsche Offenlegungsschrift DE 10 2006 016 891 A1 betrifft ein Verfahren zur Erweiterung der Funktionalität einer Serien-Software für ein Steuergerät, insbesondere für ein Steuergerät eines Kraftfahrzeugs. Die Serien-Software ist in einem nicht-flüchtigen Speicher des Steuergeräts gespeichert. Von einer externen Vorrichtung kann zusätzliche Software in einen dafür vorgesehenen flüchtigen Speicher des Steuergeräts geladen werden. Die zusätzliche Software kann vom Steuergerät ausgeführt werden und erweitert daher die Funktionalität des Steuergeräts um die durch die zusätzliche Software definierte Funktionalität, wobei es sich um eine Diagnose- und / oder Testfunktion handelt.

Die deutsche Offenlegungsschrift DE 10 2010 015 132 A1 betrifft ein Datenerhebungsverfahren und eine Datenerhebungsvorrichtung für ein Kraftfahrzeug. Im Fahrzeug ist ein Datenerhebungssteuergerät vorhanden. Über eine Schnittstelle kann ein Datenerhebungsmodul in das Datenerhebungssteuergerät geladen werden. Nach Aktivierung des Datenerhebungsmoduls werden Daten des Fahrzeugs entsprechend der Vorgaben des Datenerhebungsmoduls gesammelt. Ein Einstellen von Betriebszuständen des Kraftfahrzeugs zum Zwecke einer Diagnose ist nicht vorgesehen. Auch ist der Gegenstand der Offenlegungsschrift auf das Erheben von Daten während des regulären Betriebs des Kraftfahrzeugs gerichtet.

Das US-Patent US 5,200,900 betrifft einen Steuercomputer eines Kraftfahrzeugs, bei dem ein Benutzer zwischen verschiedenen Steuerprogrammen für den Motor des Kraftfahrzeugs wählen kann. Ein solches Steuerprogramm kann auch von einer externen Quelle nachgeladen werden.

Die deutsche Offenlegungsschrift DE 39 42 661 A1 betrifft eine insbesondere auf Kraftfahrzeuge anwendbare Einrichtung und ein entsprechendes Verfahren zur Kommunikation zwischen Datenverarbeitungsstationen. Diese Kommunikation ist zur Diagnose von Steuereinheiten des Kraftfahrzeugs vorgesehen. Eine Bedienperson wählt an einer Hauptstation einen Parameter des Kraftfahrzeugs, beispielsweise eine Motordrehzahl aus, und gibt einen gewünschten Wert vor. Die Hauptstation sendet einen entsprechenden Befehl an die zugehörige Steuereinheit. Die Steuereinheit führt diesen Befehl aus. Ferner ermittelt die Steuereinheit wiederholt den Wert des ausgewählten Parameters und übermittelt ihn an die Hauptstation, wo der Wert auf einer Anzeige für die Bedienperson dargestellt wird.

Weitere Dokumente im Umfeld der Anmeldung sind etwa DE 102 30 351 A1, DE 20 2006 003 273 U1 und DE 10 2006 009 583 A1. Eine Simulation von Teilsystemen eines Fahrzeugs ist mit dem ES910 Prototyping- und Schnittstellenmodul von ETAS möglich.

Im Dokument US 4,694,408 wird ein interaktives, kompaktes und tragbares Testsystem für Fahrzeugelektronik beschrieben. Im Testgerät können wechselbar Programmspeicherelemente aufgenommen werden, auf denen Testprozeduren gespeichert sind. Das Testgerät verfügt des Weiteren über eine Tastatur zur Eingabe von Testparametern, wobei die Belegung der Tasten abhängig von der gerade aktiven Testprozedur ist. Mittels einer Diagnoseverbindung wird das Testgerät an den Datenbus des Fahrzeugs angeschlossen, so dass Fehler auf dem Datenbus mittels der Testprozeduren erkannt werden können.

Das US-Patent US 5,491,631 betrifft ein Fehlerdiagnosesystem für Fahrzeuge mit Identifikationscode und Programmcode. Ein zum Idenfikationscode korrespondierendes vorbestimmtes Fehlerdiagnostizierprogramm wird ausgewählt und initiiert. Wenn eine Mehrzahl von fehlerhaften Teilen des Fahrzeugs detektiert worden sind, wird eine priorisierte Liste mit Fehlercodes angezeigt. Die notwendige spezifische Arbeitsprozedur wird sequentiell gemäß dem ausgewählten Fehlerdiagnostizierprogramm angezeigt.

In der europäischen Offenlegungsschrift EP 1 069 422 A1 wird ein Ferndiagnosesystem für Motorfahrzeuge mit einer lokalen Diagnoseeinheit und einer Ferndiagnoseeinheit offenbart. Die Ferndiagnoseeinheit ermöglicht einem Bediener einen Zugang zu Statusdaten des Motorfahrzeugs und die Übertragung von Steuerbefehlen an die lokale Diagnoseeinheit, so dass diese Statusdaten von einer Mehrzahl von zu diagnostizierenden Einheiten im Motorfahrzeug beeinflussen kann.

Das US-Patent US 6,314,375 B1 betrifft ein Verfahren und eine Vorrichtung zur Diagnose eines Fahrzeugs. Von außerhalb des Fahrzeugs wird ein erzwungenes Aktivierungssignal mittels einer Schnittstelle und über ein elektronisches Steuergerät des Fahrzeugs zu einem zu diagnostizierenden Teil gesendet. Ein aktueller Zustand des diagnostizierten Teils wird mit einem vorhergesagten Zustand verglichen. Aus dem Vergleich wird abgeleitet, ob der diagnostizierte Teil funktionstüchtig ist.

In der US 2012/0166036 A1 wird ein Diagnoseverfahren eines physikalischen Systems, zum Beispiel einer Fahrzeugsteuerung, offenbart, wobei das physikalische System sequentiell in eine Mehrzahl von vorbestimmten Systemzuständen überführt wird, um eine zustandsspezifische Kurve von das System charakterisierenden Größen zu erhalten. Die erhaltene Kurve wird zum Erhalt eines Diagnoseresultats analysiert. Konkret kann das physikalische System ein Kraftstoffeinspritzsystem sein. In bevorzugter Ausführungsform werden Drucksignale oder elektrische Signale betrachtet und analysiert. Es ist beschrieben, dass zu diesem Zweck die Fahrzeugsteuerung eine Analysevorrichtung umfasst.

Mit den Verfahren aus dem Stand der Technik ist die Diagnose eines Kraftfahrzeugsystems, insbesondere eines Antriebssystems, wie einer Brennkraftmaschine oder einer Elektromaschine, eines Kraftfahrzeugs nur in begrenztem Maße flexibel gestaltbar. Zwar ist es etwa möglich, vorhandene Diagnosemodule in veränderlicher, teils bedingter Reihenfolge abzuarbeiten, die sich bietenden Diagnosemöglichkeiten bleiben jedoch auf die im Steuergerät vorhandenen Diagnosemöglichkeiten beschränkt. Veränderungen sind hier nur durch eine Aktualisierung der Steuergerät-Software möglich; derartige Aktualisierungen sind von Entwicklungszyklen der Steuergerätsoftware abhängig und erlauben daher keine flexible Anpassung der Diagnosemöglichkeiten an Einzelfälle. Wird zusätzliche Software nur zum Zweck der Diagnose an das Steuergerät übertragen, so erfordert dies eine entsprechende Übertragungskapazität der Datenverbindung zwischen dem Steuergerät und einem Diagnosegerät. Die Auswertungsschritte der Diagnose werden vom Steuergerät abgearbeitet, das hierfür über entsprechende Kapazitäten verfügen muss.

Es ist daher Aufgabe der Erfindung, ein Verfahren zur Diagnose eines Kraftfahrzeugsystems bereitzustellen, welches eine flexible, an Einzelfälle leicht und unaufwändig anpassbare Ausgestaltung der Diagnose oder Fehlersuche bei einem Kraftfahrzeugsystem ermöglicht. Ebenso ist es Aufgabe der Erfindung, eine Kombination eines Diagnosegeräts und eines Kraftfahrzeugsystems mit einem Steuergerät bereitzustellen, welche eine flexible, an Einzelfälle leicht und unaufwändig anpassbare Ausgestaltung der Diagnose oder Fehlersuche bei dem Kraftfahrzeugsystem ermöglicht. Dies soll insbesondere bei einem Antriebssystem eines Kraftfahrzeugs anwendbar sein.

Obige Aufgabe hinsichtlich des Verfahrens wird gelöst durch ein Verfahren gemäß Anspruch 1. Die Aufgabe hinsichtlich der Kombination eines Diagnosegeräts und eines Kraftfahrzeugsystems wird gelöst durch den Gegenstand gemäß Anspruch 9. Die abhängigen Ansprüche enthalten vorteilhafte Ausgestaltungen. Die erfindungsgemäße Kombination eines Diagnosegeräts und eines Kraftfahrzeugsystems mit Steuergerät eignet sich insbesondere zur Durchführung des erfindungsgemäßen Verfahrens.

Ein Kraftfahrzeugsystem ist im Zusammenhang der Erfindung eine Gruppe von mechanischen und/oder elektrischen Komponenten oder Teilen, welche in einem Wirkzusammenhang stehen, (Elementen) in einem Kraftfahrzeug. Die Gruppe kann gegebenenfalls auch aus nur genau einem Element bestehen. Das Kraftfahrzeugsystem kann eine Mehrzahl von Zuständen, insbesondere von Betriebszuständen, aufweisen und/oder hat eine Wirkung auf Zustände seiner Umgebung, insbesondere auf Betriebszustände von Objekten in seiner Umgebung.

Das Kraftfahrzeugsystem kann insbesondere ein Antriebssystem eines Kraftfahrzeugs, beispielsweise eine Antriebsmaschine, wie eine Brennkraftmaschine oder eine Elektromaschine, oder eine Antriebssteuerung, wie eine Motorsteuerung oder eine Getriebesteuerung, sein.

Das erfindungsgemäße Verfahren zur Diagnose eines Kraftfahrzeugsystems wird wie folgt durchgeführt:
Zunächst wird eine Datenverbindung zwischen einem Steuergerät des Kraftfahrzeugsystems und einem Diagnosegerät hergestellt. Das Diagnosegerät ist dabei ein externes Gerät, bildet also keinen Bestandteil des Kraftfahrzeugsystems. Die Datenverbindung ist dabei von als solcher bekannter Art, kann also beispielsweise durch übliche Bussysteme realisiert werden. Ein Beispiel für ein Bussystem, welches insbesondere auch im Automobilbereich eingesetzt wird, ist FlexRay; ein anderes Beispiel sind alle Ausprägungen von CAN, wie CAN FD. Auch eine Datenverbindung auf Grundlage von TCP- und IP-Protokollen ist möglich. Die Datenübertragung mittels USB-Verbindung, durch optische Signale oder über Funk stellen weitere beispielhafte Möglichkeiten dar. Die Datenverbindung kann dabei aus einem einzigen Datenübertragungsweg, beispielsweise einem Netzwerkkabel, einem USB-Kabel oder einer WLAN-Verbindung bestehen, ebenso kann die Datenverbindung aber auch durch eine Mehrzahl von Datenübertragungswegen realisiert werden. Dabei können die verfügbaren Datenübertragungswege nach der Art der zu übertragenden Daten ausgewählt werden oder nach der Übertragungsrichtung.

Ist die Datenverbindung hergestellt, so wird mindestens ein Parametersatz vom Diagnosegerät für wenigstens ein Ansteuerungsprogramm im Steuergerät, insbesondere in einem Speicher des Steuergerätes abgelegtes und in einem Rechner des Steuergerätes ausführbares Ansteuerungsprogramm, an das Steuergerät über die Datenverbindung übertragen. Die Übertragung kann insbesondere in eine Schnittstelle hinein erfolgen. Anders gesagt kann im Steuergerät ein Schnittstellenprogramm enthalten sein, welches den mindestens einen Parametersatz vom Diagnosegerät empfängt. Das Ansteuerungsprogramm wird nachfolgend auch als Software bezeichnet. Das Ansteuerungsprogramm kann auch als eine Ablaufsteuerung bezeichnet werden. Das Ansteuerungsprogramm kann ein eigenständiges Computerprogramm oder ein Teil eines Computerprogramms im Steuergerät, zum Beispiel des Steuerungsprogramms des Kraftfahrzeugsystems, sein. Bevorzugt erfolgt eine Übertragung des mindestens einen Parametersatzes, ohne einen ausführbaren Programmcode vom Diagnosegerät an das Steuergerät zu übertragen. Es kann eine Mehrzahl von Parametersätzen für eine Mehrzahl von insbesondere verschiedenen Ansteuerungsprogrammen übertragen werden.

Es kann des Weiteren wenigstens ein Parametersatz mit Metadaten für die Auswahl des oder der Ansteuerungsprogramme im Steuergerät und/oder Ansteuerung des oder der Ansteuerungsprogramme übertragen werden. Metadaten sind insbesondere Daten der Abfolge einzelner Ansteuerungsprogramme oder der zeitlichen Terminierung des Starts einzelner Ansteuerungsprogramme.

Der wenigstens eine Parametersatz definiert mindestens einen gewünschten Betriebszustand des Kraftfahrzeugsystems, welcher zum Zwecke der Diagnose vom Kraftfahrzeugsystem eingenommen werden soll. In der Regel legt der Parametersatz eine Vielzahl von Betriebszuständen fest und bestimmt gegebenenfalls zusätzlich, in welcher Abfolge diese Betriebszustände eingenommen werden sollen. Es kann sich dabei um eine zeitlich festgelegte Abfolge handeln oder um eine Abfolge, welche von bestimmten im Parametersatz festgelegten Bedingungen, beispielsweise dem Auftreten von Messwerten bestimmter Eigenschaften des Kraftfahrzeugsystems innerhalb eines bestimmten Messwertbereichs, abhängt. Weitere Beispiele für solche Bedingungen sind etwa das Auftreten bestimmter Ergebnisse einer On-Board-Diagnose, das Resultat einer Aufbereitung von Messgrößen im Steuergerät, wie etwa ein Mittelwert oder ein Gradient der ermittelten Messgrößen, oder auch ein Status einer Komponente, beispielsweise ein "betriebsbereit"-Status einer Lambda-Sonde. Selbstverständlich können solche einzelnen Bedingungen auch durch "UND"- und "ODER"-Operatoren logisch zu komplexeren Bedingungen verknüpft werden. Der Parametersatz kann zum Beispiel Vorgaben über eine einzustellende Drehzahl des Antriebssystems enthalten, insbesondere Vorgaben über eine einzustellende Gemischzusammensetzung für eine Brennkraftmaschine oder Vorgaben über eine in einem Bereich des Kraftfahrzeugsystems einzustellende Temperatur. Diese Aufzählung von Beispielen ist nicht abschließend; die genannten Größen sind zugleich eine nicht abschließende Aufzählung von Beispielen von Größen, welche einen Betriebszustand des Kraftfahrzeugsystems kennzeichnen. Ändert sich bei einem Kraftfahrzeugsystem wenigstens eine derartige Größe, so ändert sich damit der Betriebszustand des Kraftfahrzeugsystems. Ebenso kann durch den Parametersatz vorgegeben sein, bestimmte Aktuatoren im Kraftfahrzeugsystem anzusteuern; eine Änderung einer Aktuatorstellung an sich bedeutet in diesem Fall dann ebenfalls eine Änderung des Betriebszustandes des Kraftfahrzeugsystems.

Das Steuergerät stellt sodann den wenigstens einen durch den mindestens einen Parametersatz bestimmten Betriebszustand des Kraftfahrzeugsystems ein. Das Ansteuerungsprogramm dient insbesondere dem Ansteuern des oder der betreffenden Elemente. Mit anderen Worten führt das Ansteuerungsprogramm insbesondere die Schritte durch, um die für die mit dem mindestens einen Parametersatz vom Diagnosegerät bestimmte Diagnose notwendigen Daten zu erheben. Ist das Einstellen eines bestimmten Betriebszustandes des Kraftfahrzeugsystems durch das Steuergerät zusätzlich an im Parametersatz festgelegte Bedingungen geknüpft, so kann es vorkommen, dass dieser bestimmte Betriebszustand bei der Durchführung der Diagnose nicht eingestellt wird, falls die festgelegten Bedingungen nicht eintreten. Zu mindestens einem derart vom Steuergerät eingestellten Betriebszustand wird wenigstens eine Kenngröße des Kraftfahrzeugsystems durch das Steuergerät mit dem wenigstens einen Ansteuerungsprogramm ermittelt; häufig wird zu mindestens einem derart eingestellten Betriebszustand eine Vielzahl von Kenngrößen ermittelt. Die Ermittlung der wenigstens einen Kenngröße kann etwa dadurch geschehen, dass das Steuergerät Daten von Sensoren abfragt. Bei der wenigstens einen Kenngröße kann es sich beispielsweise um die Temperatur in einem bestimmten Bereich oder einer bestimmten Komponente des Kraftfahrzeugsystems handeln, um einen Druck, eine elektrische oder mechanische Spannung, zum Beispiel eine Zusammensetzung eines Gemisches für die Brennkraftmaschine insbesondere eines Kraftfahrzeugs, eine Drehzahl des Antriebssystems oder jeglichen anderen Messwert, welcher geeignet ist, Information über den Zustand des Kraftfahrzeugsystems zu liefern. Ebenso ist es denkbar, dass die Kenngröße bestimmte, vom Steuergerät oder anderen Komponenten des Kraftfahrzeugsystems generierte Signale, beispielsweise in Form von Text, Zahlencodes oder allgemeineren Datenstrukturen, umfasst, welche Informationen über den Zustand des Kraftfahrzeugsystems darstellen. Dies beinhaltet auch Statusmeldungen von Komponenten des Kraftfahrzeugsystems.

In einer Ausführungsform ist es möglich, dass Messwerte der vorgenannten Art durch das Steuergerät aufbereitet werden, etwa indem ein Mittelwert oder ein Gradient von Messwerten gebildet wird. Der Gradient kann räumlicher oder zeitlicher Art sein; ebenso kann der Mittelwert ein Mittelwert über zeitlich hintereinander erfasste Messwerte sein oder über Messwerte von verschiedenen Orten innerhalb des Kraftfahrzeugsystems; dies kann mit einer zeitlichen Mittelung kombiniert werden. In diesen Fällen wäre der Gradient oder der Mittelwert als Kenngröße im Sinne der Anmeldung anzusehen. Ebenso kann beispielsweise auch der Maximalwert oder der Minimalwert erfasster Messwerte Kenngröße im Sinne der Anmeldung sein. Kenngröße im Sinne der Anmeldung kann auch eine Folge von Messwerten einer Messgröße sein, welche zeitlich hintereinander erfasst wurden. Zur Aufbereitung von Messwerten im Steuergerät ist es grundsätzlich möglich, dass erfasste Messwerte im Steuergerät zwischengespeichert werden; auch Kenngrößen allgemein können im Steuergerät zwischengespeichert werden.

Die zu einem im Parametersatz festgelegten Betriebszustand zu ermittelnde wenigstens eine Kenngröße wird in Ausführungsformen des erfindungsgemäßen Verfahrens ebenfalls durch den Parametersatz festgelegt. In speziellen Ausgestaltungen beinhaltet dies die Möglichkeit, über den Parametersatz die vorstehend erwähnte Aufbereitung von Messwerten im Steuergerät festzulegen, also z.B. anzugeben, ob ein Messwert direkt oder stattdessen etwa ein Mittelwert oder ein Gradient der zugehörigen Messgröße als Kenngröße des Kraftfahrzeugsystems vom Steuergerät an das Diagnosegerät übermittelt werden soll. Handelt es sich bei der gewünschten Kenngröße beispielsweise um einen zeitlichen Mittelwert oder Gradienten, so können etwa die Anzahl der für den Mittelwert oder Gradienten zu berücksichtigenden Einzel-Messwerte und der zeitliche Abstand der Messvorgänge, durch die diese Einzel-Messwerte ermittelt werden, durch den Parametersatz vorgegeben sein.

Die ermittelte wenigstens eine Kenngröße wird vom Steuergerät an das Diagnosegerät über die Datenverbindung übermittelt. Bevorzugt erfolgt eine Übertragung der ermittelten wenigstens einen Kenngröße, ohne einen ausführbaren Programmcode vom Steuergerät an das Diagnosegerät zu übertragen. Das Diagnosegerät kann die ermittelte wenigstens eine Kenngröße beim Steuergerät anfragen. Dieses kann dann in Beantwortung der Anfrage die wenigstens eine ermittelte Kenngröße übermitteln. Das Diagnosegerät wertet die übermittelte wenigstens eine Kenngröße hinsichtlich einer Funktionstauglichkeit des Kraftfahrzeugsystems aus. Eine Zwischenspeicherung von Kenngrößen im Steuergerät kann hier sinnvoll sein, wenn die Datenübertragungsrate zwischen Steuergerät und Diagnosegerät zu niedrig ist, um die Kenngrößen in Echtzeit an das Diagnosegerät zu übermitteln.

In Ausführungsformen umfasst der Parametersatz eine kryptographische Signatur zur Integrität und/oder Authentifizierung des Parametersatzes. In Ausgestaltungen des Verfahrens umfasst der Parametersatz einen Kopfabschnitt, in welchem allgemeine Angaben wie etwa Software-Versionsnummer, Bezeichnung einer durchzuführenden Diagnoseart und ähnliche Angaben enthalten sind, einen Hauptabschnitt, welcher Angaben zu den einzustellenden Betriebszuständen enthält, und einen Endabschnitt, welcher eine kryptographische Signatur des Hauptabschnitts und, in Ausführungsformen, auch des Kopfabschnitts des Parametersatzes enthält. Der Parametersatz kann in Ausführungsformen verschlüsselt sein. Das Steuergerät kann einen Login-Schutz aufweisen, so dass in Ausführungsformen auch Login-relevante Daten vom Diagnosegerät auf das Steuergerät übertragen werden.

Gegenüber Verfahren aus dem Stand der Technik hat das erfindungsgemäße Verfahren den Vorteil, dass durch den übertragenen mindestens einen Parametersatz die einzustellenden Betriebszustände flexibel festgelegt werden können, ohne ausführbaren Programmcode an das Steuergerät, sei es bei einer Aktualisierung der Steuergerät-Software oder nur vorübergehend zum Zweck der Diagnose, übertragen zu müssen. Das Verfahren nutzt die im Steuergerät implementierte Software, deren Ausführung durch den übertragenen Parametersatz beeinflusst wird. Da die Auswertung der ermittelten Kenngrößen im Diagnosegerät statt im Steuergerät erfolgt, ist auch für diese Auswertung keine Übermittlung von ausführbarem Programmcode an das Steuergerät erforderlich. Ferner können im Diagnosegerät zur Auswertung mehr Ressourcen, also insbesondere Rechenkapazität und Datenspeichergröße, bereitgestellt werden als im Steuergerät selbst. Eine Aktualisierung der Software im Diagnosegerät gestaltet sich vorteilhaft einfacher als eine Aktualisierung der Software in einer Vielzahl von Steuergeräten. Entsprechend umfangreich und flexibel ist die Auswertung und damit insbesondere auch die Fehlersuche gestaltbar. Es können auf diese Weise beispielsweise einfach und zielgerichtet konkrete Fehlerursachen bzw. fehlerhafte Bauteile ermittelt werden, wenn zunächst nur das Vorliegen eines Systemfehlers bekannt ist, dessen Ursache der zugehörigen Fehlermeldung nicht eindeutig entnehmbar ist. Es kann so insbesondere vermieden werden, bei einem Systemfehler, dessen Ursache in einem von mehreren Bauteilen liegen kann, routinemäßig alle in Frage kommenden Bauteile und damit auch korrekt arbeitende auszutauschen. Ferner ist durch die flexibel gestaltbare Diagnose eine umfassende Analyse des Kraftfahrzeugsystems möglich, etwa in Folge von Beanstandungen durch Kunden, oder in Folge eines Eintrags in einem Ereignisspeicher für das Kraftfahrzeugsystem; ein Ereignisspeicher ist dabei ein Speicherbereich im Kraftfahrzeugsystem oder im Kraftfahrzeug, in welchem das Kraftfahrzeugsystem verbaut ist, in welchem definierte auftretende Vorkommnisse, insbesondere auftretende Fehler, in Form von festgelegten Meldungen abgelegt werden. Der Inhalt des Ereignisspeichers kann beispielsweise zum Zwecke von Wartung und/oder Reparatur ausgelesen werden.

Bei dem erfindungsgemäßen Verfahren erfolgt das Einstellen des wenigstens einen Betriebszustandes des Kraftfahrzeugsystems derart, dass das Steuergerät mindestens eine Komponente des Kraftfahrzeugsystems ansteuert. Dabei werden die Auswahl der mindestens einen Komponente, also die Festlegung, welche Komponente des Kraftfahrzeugsystems angesteuert werden soll, sowie Einzelheiten der Ansteuerung der ausgewählten mindestens einen Komponente durch den mindestens einen Parametersatz bestimmt. Beispielsweise könnte der Parametersatz vorgeben, zum Beispiel das Antriebssystem auf eine bestimmte Drehzahl einzustellen und dabei gegebenenfalls bestimmte Ventile für die Kraftstoffzufuhr anzusteuern oder ein Kühlsystem für einen bestimmten Bereich eines Kraftfahrzeugsystems könnte angesteuert werden, mit der Vorgabe, eine Temperatur in dem Bereich zwischen einer durch den Parametersatz festgelegten Untergrenze und Obergrenze zu halten.

In einer Weiterbildung des erfindungsgemäßen Verfahrens wird zumindest ein Teil der ermittelten Kenngrößen des Kraftfahrzeugsystems durch mindestens ein Bewertungsmodul im Steuergerät hinsichtlich des Vorliegens einer Störung des Kraftfahrzeugsystems bewertet, das Ergebnis der Bewertung an das Diagnosegerät übermittelt und in die Auswertung im Diagnosegerät einbezogen. Die Einzelheiten einer solchen Bewertung können in Ausgestaltungen durch den mindestens einen vom Diagnosegerät an das Steuergerät übermittelten Parametersatz festgelegt werden.

In einer weiteren Ausgestaltung des erfindungsgemäßen Verfahrens wird die vom Steuergerät an das Diagnosegerät übermittelte wenigstens eine Kenngröße des Kraftfahrzeugsystems im Diagnosegerät ausgewertet und in Abhängigkeit vom Ergebnis dieser Auswertung mindestens ein weiterer Parametersatz generiert und vom Diagnosegerät an das Steuergerät übertragen. Das Steuergerät stellt dann in Abhängigkeit von dem mindestens einen weiteren Parametersatz wenigstens einen weiteren Betriebszustand des Kraftfahrzeugsystems ein und/oder ermittelt wenigstens eine weitere Kenngröße, welche dann vom Steuergerät an das Diagnosegerät zur weiteren Auswertung übermittelt wird. Hierdurch ist der Ablauf der Diagnose besonders zielgerichtet gestaltbar.

In einer Ausführungsform des erfindungsgemäßen Verfahrens wird zumindest einer der an das Steuergerät übertragenen Parametersätze von einem im Diagnosegerät ausgeführten Diagnoseprogramm erzeugt. Das Diagnoseprogramm wird nicht an das Steuergerät übermittelt. In einer weiteren Ausführungsform wird zumindest einer der an das Steuergerät übertragenen Parametersätze direkt durch einen Benutzer in das Diagnosegerät eingegeben. Es ist in diversen Ausführungsformen auch möglich, dass der Benutzer einen ersten Parametersatz direkt in das Diagnosegerät eingibt und das Diagnosegerät weitere Parametersätze in Abhängigkeit von der Auswertung der zu den bisherigen Parametersätzen vom Steuergerät erhaltenen Kenngrößen des Kraftfahrzeugsystems automatisch erzeugt. Ebenso ist es in diversen Ausführungsformen möglich, dass ein Benutzer am Diagnosegerät einen oder mehrere Diagnoseabläufe auswählt, welche dann vom Diagnosegerät abgearbeitet werden, wobei jedem Diagnoseablauf bestimmte Parametersätze durch die Software des Diagnosegeräts zugeordnet sind.

Bei einer erfindungsgemäßen Kombination ist das Diagnosegerät so ausgestaltet, dass es an ein Steuergerät eines Kraftfahrzeugsystems mittels einer Datenverbindung angeschlossen werden kann. Zur Art der Datenverbindung sei auf die obigen Ausführungen dazu im Kontext des Verfahrens verwiesen. Das Diagnosegerät umfasst erfindungsgemäß eine Software, welche derart ist, dass bei ihrer Ausführung mindestens ein Parametersatz, welcher einen Betriebszustand oder eine Abfolge von Betriebszuständen des Kraftfahrzeugsystems definiert, insbesondere für ein Ansteuerungsprogramm im Steuergerät, an das Steuergerät über die Datenverbindung übertragbar ist. Außerdem ist die Software des Diagnosegeräts in der Lage, wenigstens eine Kenngröße des Kraftfahrzeugsystems hinsichtlich einer Funktionstauglichkeit des Kraftfahrzeugsystems auszuwerten. Dabei besitzt die Software auch die Fähigkeit, eine Datenübertragung der wenigstens einen Kenngröße vom Steuergerät zum Diagnosegerät zu empfangen. Die Software im Diagnosegerät kann auch als Diagnoseprogramm bezeichnet werden.

Das Diagnosegerät umfasst insbesondere wenigstens einen Rechner und ein Speicherelement. Erfindungsgemäß ist mit anderen Worten in dem Speicherelement ein Programm abgelegt, welches bei wenigstens teilweiser Ausführung im Rechner die im vorhergehenden Absatz dieser Spezifikation beschriebenen Schritte ausführt.

Das Steuergerät eines Kraftfahrzeugsystems einer erfindungsgemäßen Kombination verfügt über eine Schnittstelle zum Herstellen einer Datenverbindung zu dem Diagnosegerät. Zur Art der Datenverbindung sei auf die obigen Ausführungen dazu im Kontext des Verfahrens verwiesen. Das Steuergerät ist gekennzeichnet durch eine Software, mittels der in Abhängigkeit von mindestens einem von dem Diagnosegerät zum Steuergerät übertragbaren Parametersatz ein Betriebszustand oder eine Abfolge von Betriebszuständen des Kraftfahrzeugsystems einstellbar ist. Ferner ist die Software des Steuergeräts in der Lage, zu mindestens einem derart eingestellten Betriebszustand des Kraftfahrzeugsystems wenigstens eine Kenngröße des Kraftfahrzeugsystems zu ermitteln und über die Schnittstelle auszugeben. Dabei erfolgt bei einer Diagnose die Ausgabe der wenigstens einen Kenngröße an das Diagnosegerät der erfindungsgemäßen Kombination.

Das Steuergerät umfasst insbesondere wenigstens einen Rechner und ein Speicherelement. Erfindungsgemäß ist mit anderen Worten in dem Speicherelement ein Programm abgelegt, welches bei wenigstens teilweiser Ausführung im Rechner die im vorhergehenden Absatz dieser Spezifikation beschriebenen Schritte ausführt.

In einer Weiterbildung umfasst das Steuergerät wenigstens ein Bewertungsmodul, durch welches zumindest ein Teil der durch das Steuergerät beziehungsweise die Software des Steuergeräts ermittelbaren Kenngrößen hinsichtlich des Vorliegens einer Störung des Kraftfahrzeugsystems bewertbar ist. Das Ergebnis der Bewertung ist über die Schnittstelle ausgebbar, bei einer Diagnose wiederum an das Diagnosegerät der erfindungsgemäßen Kombination. Die Bewertung des zumindest einen Teils der ermittelten Kenngrößen im Bewertungsmodul kann in Ausgestaltungen durch den vom Diagnosegerät zum Steuergerät übermittelten mindestens einen Parametersatz beeinflusst werden.

Durch die Software des Steuergeräts ist mindestens eine Komponente des Kraftfahrzeugsystems ansteuerbar. Durch die Ansteuerung der mindestens einen Komponente ist wenigstens ein Betriebszustand des Kraftfahrzeugsystems einstellbar. Die Auswahl der mindestens einen Komponente und ihre Ansteuerung sind dabei durch den mindestens einen Parametersatz bestimmt, welcher vom Diagnosegerät an das Steuergerät übertragbar ist. Es wird auf die diesbezüglichen Erläuterungen im Kontext des Verfahrens verwiesen. Ebenso ist es auch denkbar, dass die Software des Steuergeräts so konfiguriert ist, dass die zu einem gegebenen Betriebszustand zu ermittelnde wenigstens eine Kenngröße des Kraftfahrzeugsystems durch den mindestens einen Parametersatz bestimmbar ist.

Im Zusammenhang der Erfindung steht auch ein Kraftfahrzeug mit einem Steuergerät, welches die Merkmale oder Merkmalskombinationen gemäß dieser Spezifikation aufweist. Das Kraftfahrzeug ist insbesondere ein gleisloses Landfahrzeug, insbesondere ein Personenkraftwagen oder ein Lastkraftwagen.

Das erfindungsgemäße Verfahren kann vorteilhaft bei der Diagnose und Fehlersuche für ein Kraftfahrzeugsystem angewendet werden. Das Diagnosegerät einer erfindungsgemäßen Kombination ist dabei in der Regel ein Werkstatttester und das Steuergerät ist dabei im Kraftfahrzeug verbaut. Das Prinzip der Erfindung lässt sich grundsätzlich auch auf andere technische Anlagen als Kraftfahrzeugsysteme übertragen.

Die in dieser Spezifikation beschriebenen Merkmale der Erfindung, ihrer bevorzugten Ausführungsformen und Weiterbildungen - sei es bezüglich des Verfahrens, des Diagnosegerätes, des Steuergerätes oder des Kraftfahrzeugs - können einzeln, in Kombination oder sämtlich in konkreten Ausgestaltungen verwirklicht sein.

Im Folgenden werden bevorzugte Ausführungsformen der Erfindung und ihre Vorteile unter Bezugnahme auf die beigefügten schematischen Figuren näher erläutert.
- Figur 1: zeigt eine Ausführungsform eines Diagnosegeräts in Zusammenwirkung mit einer Ausführungsform eines Steuergeräts einer erfindungsgemäßen Kombination.
- Figur 2: zeigt eine spezielle Ausgestaltung der in Figur 1 gezeigten Ausführungsform.
- Figur 3: zeigt eine weitere Ausführungsform eines Diagnosegeräts in Zusammenwirkung mit einer weiteren Ausführungsform eines Steuergeräts einer erfindungsgemäßen Kombination.
- Figur 4: zeigt eine spezielle Ausgestaltung der in Figur 3 gezeigten Ausführungsform.

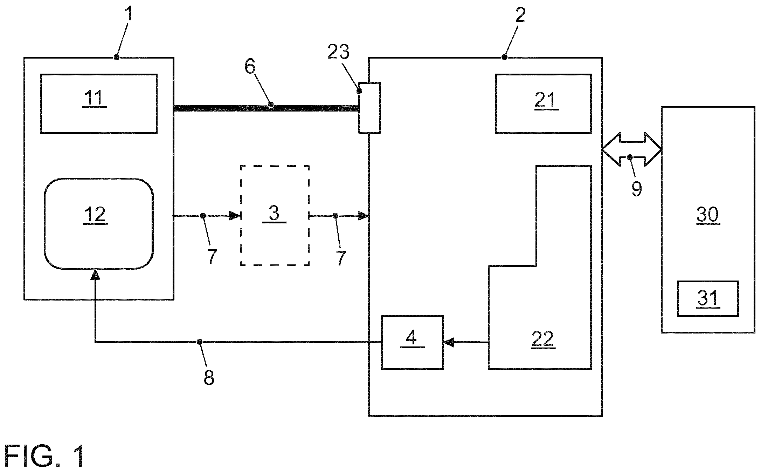

**Figur 1** zeigt eine Ausführungsform einer erfindungsgemäßen Kombination mit einem Diagnosegerät 1, welches mit einem Steuergerät 2 zusammenwirkt. Zwischen dem Diagnosegerät 1 und dem Steuergerät 2 ist eine Datenverbindung 6 hergestellt. Zum Herstellen der Datenverbindung 6 ist am Steuergerät 2 eine Schnittstelle 23 vorgesehen. Wie bereits erwähnt, kann die Datenverbindung 6 durch einen oder mehrere Datenübertragungswege realisiert sein. Der Datenaustausch zwischen Steuergerät 2 und Diagnosegerät 1 geschieht über die Datenverbindung 6. In dieser und den weiteren Figuren ist jedoch die Übermittlung bestimmter Datenarten der klaren Darstellung halber durch Pfeile 7 und 8 dargestellt, welche die Richtung der jeweiligen Datenübertragung, vom Diagnosegerät 1 zum Steuergerät 2 oder umgekehrt, angeben. Der Doppelpfeil 9 symbolisiert die Kommunikation des Steuergeräts 2 mit dem nur sehr schematisch gezeigten Kraftfahrzeugsystem 30 beziehungsweise ihren Komponenten 31, von denen hier stellvertretend und symbolisch nur eine gezeigt ist. Diese Kommunikation umfasst das Senden von Befehlen an die Komponenten 31 und das Empfangen von Daten wie Messwerten oder Statuscodes von den Komponenten 31. Je nach Komponente 31 des Kraftfahrzeugsystems 30 kann diese Kommunikation digital oder analog erfolgen.

Das Diagnosegerät 1 umfasst eine Recheneinheit 11, welche eine in dem Diagnosegerät 1 bereitgestellte Software 12 ausführen kann. Ebenso umfasst das Steuergerät 2 eine Recheneinheit 21, welche eine in dem Steuergerät 2 bereitgestellte Software 22 ausführen kann. Die Software 22 des Steuergeräts 2 dient sowohl der Steuerung des Kraftfahrzeugsystems 30 im Normalbetrieb als auch der Durchführung des in dieser Anmeldung dargelegten erfindungsgemäßen Diagnoseverfahrens. Darüber hinaus kann die Software 22 des Steuergeräts auch weitere Aufgaben haben, etwa die reguläre Überwachung des Kraftfahrzeugsystems 30 während des Normalbetriebs.

Im erfindungsgemäßen Verfahren wird mindestens ein Parametersatz 3 vom Diagnosegerät 1 an das Steuergerät 2 übertragen. Diese Übertragung ist durch die Pfeile 7 symbolisiert. Der Parametersatz 3 definiert mindestens einen Betriebszustand des Kraftfahrzeugsystems 30, welcher durch das Steuergerät 2 eingestellt wird. Hierzu arbeitet die Recheneinheit 21 des Steuergeräts 2 entsprechende Abschnitte der Software 22 des Steuergeräts 2 unter Einbeziehung des Parametersatzes 3 ab; dabei kommuniziert, dargestellt durch den Doppelpfeil 9, die Recheneinheit 21 mit Komponenten 31 des Kraftfahrzeugsystems 30, um die Einstellung des durch den Parametersatz 3 definierten mindestens einen Betriebszustands des Kraftfahrzeugsystems 30 zu erzielen.

Es wird von Komponenten 31 des Kraftfahrzeugsystems 30, beispielsweise von Sensoren, wenigstens eine Kenngröße 4 des Kraftfahrzeugsystems 30 an das Steuergerät 2 gemeldet und vom Steuergerät 2 an das Diagnosegerät 1 übermittelt. Diese Übermittlung ist durch den Pfeil 8 dargestellt. Durch Abarbeitung entsprechender Abschnitte der Software 12 des Diagnosegeräts 1 führt das Diagnosegerät 1 eine Auswertung der übermittelten wenigstens einen Kenngröße 4 durch. Ziel der Auswertung ist eine Aussage über die Funktionstauglichkeit des Kraftfahrzeugsystems 30, etwa eine Fehlerdiagnose. Alternativ kann die Kenngröße 4 auch eine Kenngröße sein, welche erst vom Steuergerät 2 aus von den Komponenten 31 an das Steuergerät 2 gemeldeten Messwerten und / oder anderen Informationen, wie etwa StatusCodes, gebildet wird. Es sei hierbei auf die Ausführungen zum Begriff Kenngröße im einleitenden Teil der Beschreibung verwiesen.

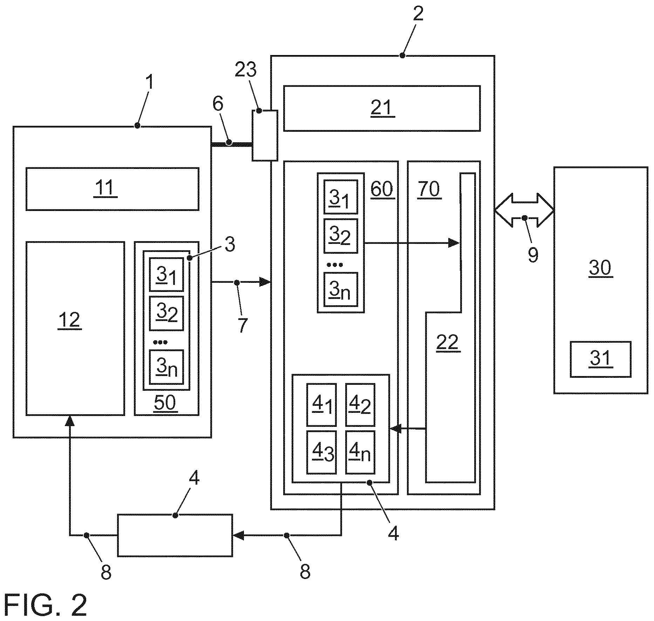

**Figur 2** zeigt eine spezielle Ausgestaltung von Steuergerät 2 und Diagnosegerät 1 der in Figur 1 dargestellten Art. Etliche Elemente der Figur 2 wurden bereits im Zusammenhang mit der Figur 1 beschrieben. In der Ausführungsform nach Figur 2 wird der Parametersatz 3, welcher hier Parameter 31, 32 bis 3n umfasst, zunächst in einem Speicher 50 des Diagnosegeräts 1 gespeichert. Der Parametersatz 3 kann, wie bereits erwähnt, durch einen Benutzer in das Diagnosegerät 1 eingegeben oder durch die Abarbeitung einer Software 12 des Diagnosegeräts erzeugt werden; weitere beispielhafte Möglichkeiten, welche nicht auf diese Ausführungsform beschränkt sind, sind, dass das Diagnosegerät 1 den Parametersatz 3 über ein Netzwerk von einem Server bezieht oder von einem Speichermedium einliest. Vom Speicher 50 des Diagnosegeräts 1 wird der Parametersatz 3, wie es durch den Pfeil 7 angedeutet ist, an das Steuergerät 2 übertragen; genauer wird der Parametersatz 3 in einen RAM-Speicher 60 des Steuergeräts 2 geschrieben. Die Software 22 des Steuergeräts 2 ist in einem ROM-Speicher 70 des Steuergeräts 2 abgelegt. Die Recheneinheit 21 arbeitet Abschnitte der Software 22 unter Einbeziehung des Parametersatzes 3 ab, und ermittelt in der gezeigten Ausführungsform Kenngrößen 41, 42 bis 4n des Kraftfahrzeugsystems 30. Dies involviert, wie bereits zu Figur 1 dargelegt, Kommunikation 9 mit dem Kraftfahrzeugsystem 30 beziehungsweise ihren Komponenten 31. Der Satz 4 an ermittelten Kenngrößen 41, 42 bis 4ₙ wird zunächst in den RAM-Speicher 60 des Steuergeräts 2 geschrieben und von dort, dargestellt durch die Pfeile 8, an das Diagnosegerät 1 übertragen, wo er Schritten der Auswertung und darauf aufbauend gegebenenfalls der geführten Fehlersuche zugeführt wird, welche von der Recheneinheit 11 des Diagnosegeräts 1 durch Abarbeitung von Abschnitten der Software 12 des Diagnosegeräts 1 ausgeführt werden.

Alternativ zu der hier gezeigten Speicherung des Parametersatzes 3 im RAM-Speicher 60 des Steuergeräts 2 kann der Parametersatz 3 in abgewandelten Ausführungsformen auch in den ROM-Speicher 70 des Steuergeräts 2 eingetragen werden, etwa über einen sogenannten Flash-Prozess.

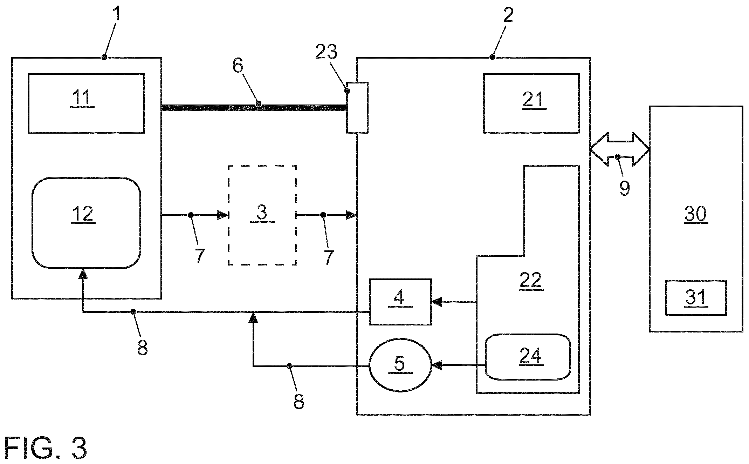

**Figur 3** zeigt eine Ausführungsform, bei welcher die Funktionalität des Steuergeräts 2 gegenüber der Ausführungsform in Figur 1 erweitert ist. Der überwiegende Teil der dargestellten Elemente wurde bereits in Zusammenhang mit Figur 1 erläutert. In der in Figur 3 gezeigten Ausführungsform weist das Steuergerät 2 ein Bewertungsmodul 24 auf. Das Bewertungsmodul 24 bildet bevorzugt einen Teil der Software 22 des Steuergeräts 2, wie hier dargestellt. Unabhängige Implementierungen des Bewertungsmoduls 24, insbesondere auch in Hardware, wären prinzipiell ebenfalls denkbar. Das Bewertungsmodul 24 führt innerhalb des Steuergeräts 2 eine Bewertung zumindest eines Teils der ermittelten Kenngrößen 4 des Kraftfahrzeugsystems 30 hinsichtlich einer Funktionstauglichkeit des Kraftfahrzeugsystems 30 durch. Anschließend, dargestellt durch einen Pfeil 8, wird ein Ergebnis 5 dieser Bewertung zusammen mit ermittelten Kenngrößen 4 des Kraftfahrzeugsystems 30 an das Diagnosegerät 1 übermittelt und fließt dort in die Auswertung der übermittelten Kenngrößen 4 ein. Wie bereits erwähnt, kann die Bewertung zumindest eines Teils der ermittelten Kenngrößen 4 durch das Bewertungsmodul 24 in Ausgestaltungen durch den vom Diagnosegerät 1 zum Steuergerät 2 übermittelten mindestens einen Parametersatz 3 beeinflusst werden.

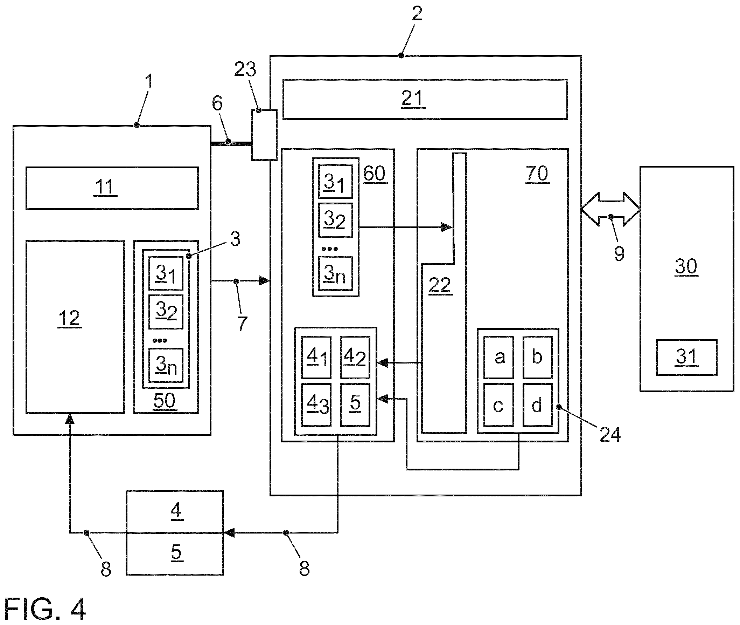

**Figur 4** zeigt eine spezielle Ausgestaltung von Steuergerät 2 und Diagnosegerät 1 der in Figur 3 dargestellten Art und stellt auch eine Ausführungsform dar, bei der die Funktionalität des Steuergeräts 2 gegenüber der Ausführungsform der Figur 2 erweitert worden ist. Etliche Elemente der Figur 4 wurden bereits im Zusammenhang mit den Figuren 2 und 3 beschrieben. Das im ROM-Speicher 70 des Steuergeräts 2 hinterlegte Bewertungsmodul 24 umfasst in der gezeigten Ausführungsform vier Bewertungsroutinen a, b, c, d, deren Abarbeitung durch die Recheneinheit 21 des Steuergeräts 2 jeweils zu einer Bewertung der Funktionstauglichkeit von durch die jeweilige Bewertungsroutine a, b, c, d bestimmten Komponenten 31 des Kraftfahrzeugsystems 30 führt. Das Ergebnis 5 einer solchen Bewertung besteht in der gezeigten Ausführungsform für jede der jeweils bestimmten Komponenten 31 in einer Aussage der Art "Komponente in Ordnung" oder "Komponente nicht in Ordnung", je nach Ergebnis der Bewertung. Genauere Ergebnisse der Abarbeitung der Bewertungsroutinen a, b, c, d sind ebenfalls denkbar. Das Ergebnis 5 einer Bewertung wird zunächst in den RAM-Speicher 60 des Steuergeräts 2 geschrieben, in welchem sich auch die analog zu den Ausführungen zur Figur 3 ermittelten Kenngrößen 4, hier 41, 42, 43, befinden. Die Kenngrößen 4 und das Ergebnis 5 der Bewertung werden dann, dargestellt durch Pfeile 8, an das Diagnosegerät 1 übermittelt, wo sie Schritten der Auswertung und darauf aufbauend gegebenenfalls der geführten Fehlersuche zugeführt werden, welche von der Recheneinheit 11 des Diagnosegeräts 1 durch Abarbeitung von Abschnitten der Software 12 des Diagnosegeräts 1 ausgeführt werden.

### Bezugszeichenliste

- 1: Diagnosegerät
- 2: Steuergerät
- 3: Parametersatz
- 3₁, 3₂, 3ₙ: Parameter
- 4: Kenngröße
- 4₁, 4₂, 4₃, 4ₙ: Kenngröße
- 5: Ergebnis einer Bewertung
- 6: Datenverbindung
- 7: Pfeil
- 8: Pfeil
- 9: Doppelpfeil
- 11: Recheneinheit
- 12: Software Diagnosegerät
- 21: Recheneinheit
- 22: Software Steuergerät
- 23: Schnittstelle
- 24: Bewertungsmodul
- 30: Kraftfahrzeugsystem
- 31: Komponente des Kraftfahrzeugsystems
- 50: Speicher im Diagnosegerät
- 60: RAM-Speicher im Steuergerät
- 70: ROM-Speicher im Steuergerät
- a, b, c, d: Bewertungsroutine

## Patentansprüche

1. Verfahren zur Diagnose eines Kraftfahrzeugsystems (30) mit einem Steuergerät (2), umfassend die Schritte:
• Herstellen einer Datenverbindung (6) zwischen dem Steuergerät (2) des Kraftfahrzeugsystems (30) und einem Diagnosegerät (1), welches kein Bestandteil des Kraftfahrzeugsystems (30) ist;
• Übertragen mindestens eines Parametersatzes (3), welcher mindestens einen gewünschten Betriebszustand des Kraftfahrzeugsystems (30) definiert, für wenigstens ein Ansteuerungsprogramm im Steuergerät (2) vom Diagnosegerät (1) an das Steuergerät (2) über die Datenverbindung (6);
• Einstellen wenigstens eines durch den mindestens einen Parametersatz (3) bestimmten Betriebszustandes des Kraftfahrzeugsystems (30) durch das Steuergerät (2) und Ermitteln wenigstens einer Kenngröße (4) des Kraftfahrzeugsystems (30) zu mindestens einem der so eingestellten Betriebszustände mit dem wenigstens einen Ansteuerungsprogramm in Abhängigkeit des übertragenen mindestens einen Parametersatzes (3) durch das Steuergerät (2);
• Übermitteln der ermittelten wenigstens einen Kenngröße (4) vom Steuergerät (2) an das Diagnosegerät (1) über die Datenverbindung (6); und
• Auswerten der übermittelten wenigstens einen Kenngröße (4) hinsichtlich einer Funktionstauglichkeit des Kraftfahrzeugsystems (30) durch das Diagnosegerät (1),
wobei das Einstellen des wenigstens einen Betriebszustandes des Kraftfahrzeugsystems (30) durch Ansteuern mindestens einer Komponente (31) des Kraftfahrzeugsystems (30) erfolgt und die Auswahl der mindestens einen Komponente (31) und ihre Ansteuerung durch den mindestens einen Parametersatz (3) bestimmt werden.

2. Verfahren nach Anspruch 1, wobei zumindest ein Teil der ermittelten Kenngrößen (4) des Kraftfahrzeugsystems (30) durch mindestens ein Bewertungsmodul (24) im Steuergerät (2) hinsichtlich des Vorliegens einer Störung des Kraftfahrzeugsystems (30) bewertet wird, ein Ergebnis (5) der Bewertung an das Diagnosegerät (1) übermittelt und in die Auswertung im Diagnosegerät (1) einbezogen wird.

3. Verfahren nach Anspruch 1, wobei mindestens ein weiterer Parametersatz (3) in Abhängigkeit vom Ergebnis der Auswertung der übermittelten wenigstens einen Kenngröße (4) generiert und vom Diagnosegerät (1) an das Steuergerät (2) übertragen wird, und das Steuergerät (2) in Abhängigkeit von dem mindestens einen weiteren Parametersatz (3) wenigstens einen weiteren Betriebszustand des Kraftfahrzeugsystems (30) einstellt und / oder wenigstens eine weitere Kenngröße (4) ermittelt und an das Diagnosegerät zur Auswertung übermittelt.

4. Verfahren nach Anspruch 1, wobei der mindestens eine Parametersatz (3) übertragen wird, ohne dass ein ausführbarer Programmcode des Ansteuerungsprogramms vom Diagnosegerät (1) an das Steuergerät (2) übertragen wird.

5. Verfahren nach Anspruch 1, wobei eine Übertragung der mindestens einen Kenngröße (4) erfolgt, ohne dass ein ausführbarer Programmcode vom Steuergerät (3) an das Diagnosegerät (1) übertragen wird.

6. Verfahren nach Anspruch 1, wobei zumindest einer der gemäß dem Anspruch 1 an das Steuergerät übertragenen Parametersätze (3) eine kryptographische Signatur umfasst und / oder wobei der Parametersatz (3) verschlüsselt ist.

7. Verfahren nach Anspruch 1, wobei das Ermitteln der wenigstens einen Kenngröße (4) im Steuergerät (2) eine Aufbereitung von an das Steuergerät (2) gesendeten Messwerten im Steuergerät (2) umfasst, bevor die derart ermittelte wenigstens eine Kenngröße (4) an das Diagnosegerät (1) übermittelt wird.

8. Verfahren nach Anspruch 1, wobei wenigstens ein Parametersatz mit Metadaten für die Auswahl des oder der Ansteuerungsprogramme im Steuergerät und/oder für die Ansteuerung des oder der Ansteuerungsprogramme übertragen wird.

9. Kombination eines Diagnosegeräts (1) und eines Kraftfahrzeugsystems (30) mit einem Steuergerät (2), wobei
das Diagnosegerät (1) kein Bestandteil des Kraftfahrzeugsystems (30) ist und zum Anschluss an das Steuergerät (2) mittels einer Datenverbindung (6) vorgesehen ist und wobei das Diagnosegerät (1) eine Software (12) umfasst, mittels der mindestens ein Parametersatz (3), welcher einen Betriebszustand oder eine Abfolge von Betriebszuständen des Kraftfahrzeugsystems (30) definiert, an das Steuergerät (2) über die Datenverbindung (6) übertragbar ist und mittels der wenigstens eine Kenngröße (4) des Kraftfahrzeugsystems (30) hinsichtlich einer Funktionstauglichkeit des Kraftfahrzeugsystems (30) auswertbar ist, und wobei
das Steuergerät (2) eine Schnittstelle (23) zum Herstellen einer Datenverbindung (6) zu dem Diagnosegerät (1) und eine Software (22) aufweist, mittels der in Abhängigkeit von mindestens einem von dem Diagnosegerät (1) zum Steuergerät (2) übertragbaren Parametersatz (3), welcher mindestens einen gewünschten Betriebszustand des Kraftfahrzeugsystems (30) definiert, wenigstens ein Betriebszustand des Kraftfahrzeugsystems (30) einstellbar ist und mittels der zu dem mindestens einen so einstellbaren Betriebszustand des Kraftfahrzeugsystems (30) wenigstens eine Kenngröße (4) des Kraftfahrzeugsystems (30) ermittelbar und über die Schnittstelle (23) ausgebbar ist, wobei das Einstellen des wenigstens einen Betriebszustandes des Kraftfahrzeugsystems (30) durch Ansteuern mindestens einer Komponente (31) des Kraftfahrzeugsystems (30) erfolgt und die Auswahl der mindestens einen Komponente (31) und ihre Ansteuerung durch den mindestens einen Parametersatz (3) bestimmt sind.

10. Kombination nach Anspruch 9, wobei das Steuergerät (2) wenigstens ein Bewertungsmodul (24) umfasst, durch welches zumindest ein Teil der ermittelbaren Kenngrößen (4) hinsichtlich des Vorliegens einer Störung des Kraftfahrzeugsystems (30) bewertbar ist und wobei ein Ergebnis (5) der Bewertung über die Schnittstelle (23) ausgebbar ist.

11. Kombination nach Anspruch 9, wobei das Kraftfahrzeugsystem ein Antriebssystem eines Kraftfahrzeugs (30) ist.

12. Kombination nach Anspruch 11, wobei das Kraftfahrzeugsystem eine Antriebssteuerung des Kraftfahrzeugs (30) ist.

## Claims

1. Method for diagnosing a motor vehicle system (30) having a control device (2), comprising the steps of:
• establishing a data connection (6) between the control device (2) of the motor vehicle system (30) and a diagnostic device (1) which is not part of the motor vehicle system (30);
• transmitting at least one parameter set (3), which defines at least one desired operating state of the motor vehicle system (30), for at least one control program in the control device (2), from the diagnostic device (1) to the control device (2) via the data connection (6);
• setting at least one operating state of the motor vehicle system (30), as determined by the at least one parameter set (3), by means of the control device (2) and determining at least one characteristic variable (4) of the motor vehicle system (30) for at least one of the operating states set in this manner with the at least one control program on the basis of the transmitted at least one parameter set (3) by means of the control device (2);
• transmitting the determined at least one characteristic variable (4) from the control device (2) to the diagnostic device (1) via the data connection (6); and
• evaluating the transmitted at least one characteristic variable (4) with regard to a functional capability of the motor vehicle system (30) by means of the diagnostic device (1),
wherein the at least one operating state of the motor vehicle system (30) is set by controlling at least one component (31) of the motor vehicle system (30), and the selection of the at least one component (31) and its control are determined by the at least one parameter set (3).

2. Method according to Claim 1, wherein at least some of the determined characteristic variables (4) of the motor vehicle system (30) are assessed by at least one assessment module (24) in the control device (2) with regard to the presence of a fault in the motor vehicle system (30), a result (5) of the assessment is transmitted to the diagnostic device (1) and is included in the evaluation in the diagnostic device (1).

3. Method according to Claim 1, wherein at least one further parameter set (3) is generated on the basis of the result of the evaluation of the transmitted at least one characteristic variable (4) and is transmitted from the diagnostic device (1) to the control device (2), and, on the basis of the at least one further parameter set (3), the control device (2) sets at least one further operating state of the motor vehicle system (30) and/or determines at least one further characteristic variable (4) and transmits it to the diagnostic device for evaluation.

4. Method according to Claim 1, wherein the at least one parameter set (3) is transmitted without transmitting an executable program code of the control program from the diagnostic device (1) to the control device (2).

5. Method according to Claim 1, wherein the at least one characteristic variable (4) is transmitted without transmitting an executable program code from the control device (3) to the diagnostic device (1).

6. Method according to Claim 1, wherein at least one of the parameter sets (3) transmitted to the control device according to Claim 1 comprises a cryptographic signature, and/or wherein the parameter set (3) is encrypted.

7. Method according to Claim 1, wherein the determination of the at least one characteristic variable (4) in the control device (2) comprises preprocessing measured values transmitted to the control device (2) in the control device (2) before the at least one characteristic variable (4) determined in this manner is transmitted to the diagnostic device (1).

8. Method according to Claim 1, wherein at least one parameter set having metadata for the selection of the control program(s) in the control device and/or for the control of the control program(s) is transmitted.

9. Combination of a diagnostic device (1) and a motor vehicle system (30) with a control device (2), wherein
the diagnostic device (1) is not part of the motor vehicle system (30) and is intended to be connected to the control device (2) by means of a data connection (6), and wherein the diagnostic device (1) comprises software (12) which can be used to transmit at least one parameter set (3), which defines an operating state or a sequence of operating states of the motor vehicle system (30), to the control device (2) via the data connection (6) and to evaluate at least one characteristic variable (4) of the motor vehicle system (30) with regard to a functional capability of the motor vehicle system (30), and wherein
the control device (2) has an interface (23) for establishing a data connection (6) to the diagnostic device (1) and software (22) which can be used to set at least one operating state of the motor vehicle system (30) on the basis of at least one parameter set (3), which can be transmitted from the diagnostic device (1) to the control device (2) and defines at least one desired operating state of the motor vehicle system (30), and can be used to determine at least one characteristic variable (4) of the motor vehicle system (30) for the at least one operating state of the motor vehicle system (30) which can be set in this manner and to output it via the interface (23),
wherein the at least one operating state of the motor vehicle system (30) is set by controlling at least one component (31) of the motor vehicle system (30), and the selection of the at least one component (31) and its control are determined by the at least one parameter set (3).

10. Combination according to Claim 9, wherein the control device (2) comprises at least one assessment module (24) which can be used to assess at least some of the determinable characteristic variables (4) with regard to the presence of a fault in the motor vehicle system (30), and wherein a result (5) of the assessment can be output via the interface (23).

11. Combination according to Claim 9, wherein the motor vehicle system is a drive system of a motor vehicle (30).

12. Combination according to Claim 11, wherein the motor vehicle system is a drive controller of the motor vehicle (30).

## Revendications

1. Procédé de diagnostic d'un système de véhicule automobile (30) avec un contrôleur (2), comprenant les étapes suivantes :
* établissement d'une liaison de données (6) entre le contrôleur (2) du système de véhicule automobile (30) et un appareil de diagnostic (1) qui ne fait pas partie du système de véhicule automobile (30) ;
* transmission d'au moins un jeu de paramètres (3), lequel définit un état de fonctionnement souhaité du système de véhicule automobile (30), pour au moins un programme de commande dans le contrôleur (2) de l'appareil de diagnostic (1) au contrôleur (2) par le biais de la liaison de données (6) ;
* réglage, par le contrôleur (2), d'au moins un état de fonctionnement du système de véhicule automobile (30) défini par l'au moins un jeu de paramètres (3) et détermination, par le contrôleur (2), d'au moins une grandeur caractéristique (4) du système de véhicule automobile (30) à propos d'au moins l'un des états de fonctionnement ainsi réglé avec l'au moins un programme de commande en fonction de l'au moins un jeu de paramètres (3) transmis ;
* transmission de l'au moins une grandeur caractéristique (4) du contrôleur (2) à l'appareil de diagnostic (1) par le biais de la liaison de données (6) ; et
* interprétation, par l'appareil de diagnostic (1), de l'au moins une grandeur caractéristique (4) transmise du point de vue d'une aptitude au fonctionnement du système de véhicule automobile (30), le réglage de l'au moins un état de fonctionnement du système de véhicule automobile (30) s'effectuant en commandant au moins un composant (31) du système de véhicule automobile (30) et la sélection de l'au moins un composant (31) ainsi que sa commande étant définies par l'au moins un jeu de paramètres (3).

2. Procédé selon la revendication 1, au moins une partie des grandeurs caractéristiques (4) déterminées du système de véhicule automobile (30) étant évaluée par au moins un module d'évaluation (24) dans le contrôleur (2) en vue de la présence d'une perturbation du système de véhicule automobile (30), un résultat (5) de l'évaluation étant communiqué à l'appareil de diagnostic (1) et l'interprétation étant incorporée dans l'appareil de diagnostic (1).

3. Procédé selon la revendication 1, au moins un jeu de paramètres (3) supplémentaire étant généré en fonction du résultat de l'interprétation de l'au moins une grandeur caractéristique (4) communiquée, puis transmis de l'appareil de diagnostic (1) au contrôleur (2) et, en fonction de l'au moins un jeu de paramètres (3) supplémentaire, le contrôleur (2) réglant au moins un état de fonctionnement supplémentaire du système de véhicule automobile (30) et/ou déterminant au moins une grandeur caractéristique (4) supplémentaire et la communiquant à l'appareil de diagnostic pour évaluation.

4. Procédé selon la revendication 1, l'au moins un jeu de paramètres (3) étant transmis sans qu'un code de programme exécutable du programme de commande soit transmis de l'appareil de diagnostic (1) au contrôleur (2) .

5. Procédé selon la revendication 1, une transmission de l'au moins une grandeur caractéristique (4) s'effectuant sans qu'un code de programme exécutable soit transmis du contrôleur (2) à l'appareil de diagnostic (1).

6. Procédé selon la revendication 1, au moins l'un des jeux de paramètres (3) transmis au contrôleur conformément à la revendication 1 comportant une signature cryptographique et/ou le jeu de paramètres (3) étant chiffré.

7. Procédé selon la revendication 1, la détermination de l'au moins une grandeur caractéristique (4) dans le contrôleur (4) comprenant une préparation dans le contrôleur (4) de valeurs mesurées envoyées au contrôleur (4) avant que l'au moins une grandeur caractéristique (4) ainsi déterminée soit communiquée à l'appareil de diagnostic (1).

8. Procédé selon la revendication 1, au moins un jeu de paramètres étant transmis avec des métadonnées pour la sélection du ou des programmes de commande dans le contrôleur et/ou pour la commande du ou des programmes de commande.

9. Combinaison d'un appareil de diagnostic (1) et d'un système de véhicule automobile (30) avec un contrôleur (2),
l'appareil de diagnostic (1) ne faisant pas partie du système de véhicule automobile (30) et étant conçu pour être raccordé au contrôleur (2) au moyen d'une liaison de données (6)
et l'appareil de diagnostic (1) comprenant un logiciel (12) au moyen duquel au moins un jeu de paramètres (3), lequel définit un état de fonctionnement souhaité ou une séquence d'états de fonctionnement du système de véhicule automobile (30), peut être transmis au contrôleur (2) par le biais de la liaison de données (6) et au moyen duquel l'au moins une grandeur caractéristique (4) du système de véhicule automobile (30) peut être évaluée du point de vue d'une aptitude au fonctionnement du système de véhicule automobile (30), et
le contrôleur (2) possédant une interface (23) servant à établir une liaison de données (6) avec l'appareil de diagnostic (1) et un logiciel (22) au moyen duquel le réglage d'au moins un état de fonctionnement du système de véhicule automobile (30) peut être effectué en fonction d'au moins un jeu de paramètres (3) pouvant être transmis de l'appareil de diagnostic (1) au contrôleur (2), lequel définit au moins un état de fonctionnement souhaité du système de véhicule automobile (30), et au moyen duquel l'au moins une grandeur caractéristique (4) du système de véhicule automobile (30) à propos de l'état de fonctionnement du système de véhicule automobile (30) ainsi réglable peut être déterminée et délivrée par le biais de l'interface,
le réglage de l'au moins un état de fonctionnement du système de véhicule automobile (30) s'effectuant en commandant au moins un composant (31) du système de véhicule automobile (30) et la sélection de l'au moins un composant (31) ainsi que sa commande étant définies par l'au moins un jeu de paramètres (3).

10. Combinaison selon la revendication 9, le contrôleur (2) comportant au moins un module d'évaluation (24) par lequel au moins une partie des grandeurs caractéristiques (4) peut être évaluée en vue de la présence d'une perturbation du système de véhicule automobile (30), et un résultat (5) de l'évaluation pouvant être délivré par le biais de l'interface (23).

11. Combinaison selon la revendication 9, le système de véhicule automobile étant un système de propulsion d'un véhicule automobile (30).

12. Combinaison selon la revendication 11, le système de véhicule automobile étant une commande de propulsion du véhicule automobile (30).
